# EUROPÄISCHE PATENTSCHRIFT

(11) **EP 3 611 528 B1**
(45) Veröffentlichungstag und Bekanntmachung des Hinweises auf die Patenterteilung: **22.05.2024**
(21) Anmeldenummer: 19187678.8
(22) Anmeldetag: 22.07.2019
(51) Int. Cl.: G01R 33/38, G01R 33/3815, H01F 6/04

(54) **KRYOSTATANORDNUNG MIT SUPRALEITENDEM MAGNETSPULENSYSTEM MIT THERMISCHER VERANKERUNG DER BEFESTIGUNGSSTRUKTUR**
CRYOSTAT ARRANGEMENT WITH SUPERCONDUCTING MAGNETIC COIL SYSTEM WITH THERMAL ANCHORING OF THE FIXING STRUCTURE
DISPOSITIF CRYOSTAT POURVU DE SYSTÈME DE BOBINES MAGNÉTIQUES SUPRACONDUCTEUR À ANCRAGE THERMIQUE DE LA STRUCTURE DE FIXATION

(30) Priorität: 31.07.2018 DE 102018212758
(43) Veröffentlichungstag der Anmeldung: 19.02.2020
(73) Patentinhaber: Bruker Switzerland AG, 8117 Fällanden (CH)
(72) Erfinder: WIKUS, Patrick, 8309 Nürensdorf (CH); BONN, Steffen, 8050 Zürich (CH); STROBEL, Marco, 76137 Karlsruhe (DE)
(74) Vertreter: Kohler Schmid Möbus Patentanwälte

(56) Entgegenhaltungen:
- EP-A2- 0 260 036
- EP-A2- 0 284 875
- EP-B1- 1 742 234
- DE-A1- 4 039 365
- GB-A- 2 463 659
- US-A- 5 220 800

## Beschreibung

Die Erfindung betrifft eine Kryostatanordnung mit einem Außenbehälter, in welchem ein Vorratstank mit einem ersten kryogenen Fluid und ein Spulentank mit einem zu kühlenden supraleitenden Magnetspulensystem angeordnet sind, wobei das Magnetspulensystem von einem zweiten kryogenen Fluid gekühlt ist, dessen Temperatur unter der des ersten kryogenen Fluids liegt, wobei der Spulentank mittels einer Befestigungsstruktur mit dem Außenbehälter und/oder einem oder mehreren den Spulentank umgebenden Strahlungsschilden mechanisch verbunden ist, und wobei als erstes kryogenes Fluid im Vorratstank flüssiges Helium bei einer Betriebstemperatur von etwa 4,2 K und als zweites kryogenes Fluid im Spulentank Helium bei einer Betriebstemperatur kleiner als 3.5 K gewählt sind.

Eine solche Kryostatanordnung ist etwa aus der EP 1 742 234 B1 bzw. US 2010/0236260 A1 (= Referenz [1]) bekannt geworden.

### Hintergrund der Erfindung

Die vorliegende Erfindung betrifft allgemein den Bereich der Kühlung von supraleitenden Magnetanordnungen, welche im Betrieb auf sehr tiefen (=kryogenen) Temperaturen gehalten werden sollen/müssen. Derartige supraleitenden Magnetanordnungen werden etwa auf dem Gebiet der Magnetresonanz, beispielsweise in MRI-Tomographen oder NMR-Spektrometern eingesetzt. Sie werden üblicherweise mit flüssigem Helium als kryogenem Fluid gekühlt.

Für hochauflösende MRI (Magnetic Resonance Imaging) und FT-ICR (Fourier Transform Ion Cyclotron Resonance) Messungen werden supraleitende Magnetsysteme mit horizontaler Bohrung benötigt. Für hohe Feldstärken, wie sie besonders für hochauflösende Messungen nötig sind, ist es von Vorteil, die Magnetspule anstatt auf nur 4,2 K (der Siedepunkt flüssigen Heliums bei Atmosphärendruck) auf etwa 2 K abzukühlen, da hierdurch der Supraleiter in der Magnetspule höher ausgelastet werden kann.

Zur Unterkühlung von Magnetsystemen ist es vorteilhaft, die in US-A 5,220,800 (=Referenz [2]) beschriebene Technologie einzusetzen, die äußerst zuverlässig ist und sich in vielen Anwendersystemen bewährt hat.

Bei Horizontal-Magnetsystemen hat es sich im Markt durchgesetzt, dass diese kalttransportierbar sind, d.h. der Kryostat muss den mechanischen Lasten, die bei einem Transport per Flugzeug, Bahn, Schiff, Lastwagen, etc. auftreten, standhalten können.

Typischerweise wird dieses Problem eines kalttransportierbaren, unterkühlten Horizontal-Magnetsystems so gelöst, dass die mechanischen Befestigungen direkt am Spulentank angreifen. Dies ist vorteilhaft, da die Magnetspule bei weitem der schwerste Teil des Systems ist, und auf diese Weise mechanisch ein besonders kurzer Weg zwischen dem Außenbehälter und der Spule hergestellt wird.

Üblicherweise umfassen die mechanischen Befestigungen Streben, welche so angeordnet sind, dass sie den Außenbehälter mit dem thermischen Schild und den thermischen Schild mit dem Spulentank verbinden. Für diese Streben wird im Stand der Technik ein Material verwendet, das ein gutes Verhältnis aus mechanischer Festigkeit und Wärmeleitfähigkeit bietet, z.B. Stahl oder GFK.

Zum Vergleich: Bei unterkühlten Vertikalmagnetsystemen, die nicht kalt transportiert werden, hängt der Spulentank am Vorratstank, und hat selbst keine direkte mechanische Verbindung zum Stickstofftank oder zum Strahlungsschild.

Der Ansatz, die mechanischen Befestigungen direkt am Spulentank angreifen zu lassen, hat außerdem zum Vorteil, dass der Spulentank über Einstellung der mechanischen Aufhängung in alle Richtungen bewegt werden kann, und so die Spalte zwischen dem Raumtemperaturrohr der Bohrung und dem Innenrohr des Heliumtanks und gegebenenfalls dazwischenliegenden Strahlungsschilden besonders einfach eingestellt werden können.

Die Spaltmaße in diesem Bereich sind typischerweise sehr klein, um ein effizientes Magnetdesign zu ermöglichen. Berührungen zwischen den Rohren müssen jedoch unbedingt vermieden werden, da die Wärmelasten auf die kalten Teile des Kryostaten sonst unzulässig hoch würden.

Oftmals werden supraleitende Magnetsysteme auch mit einer aktiven Kühlung ausgerüstet. Die Systeme verfügen dann zumeist über gar keinen Stickstofftank mehr. Die Strahlungsschilde werden von einem aktiven Kühler gekühlt, z.B. von einem Pulsrohr- oder GM-Kühler.

In der US-A 5,586,437 (=Referenz [3]) wird ein Kryostat mit zwei "Thermal Intercepts" beschrieben. Dieser Kryostat weist allerdings keine zwei Heliumtanks auf. Außerdem wird für den ersten "Thermal Intercept" zwingend eine Gaskühlung, und für den zweiten "Intercept" zwingend ein aktiver Kühler ("Evaporator") vorgeschrieben.

In der US-A 6,011,454 (=Referenz [4]) wird eine Befestigungsstruktur für einen supraleitenden Magneten beschrieben. Konkret werden faserverstärkte Werkstoffe vorgeschlagen. Auch wird konkret auf die Notwendigkeit der "Thermal Interception" hingewiesen sowie darauf, Teile mit guter thermischer Leitfähigkeit als Kontaktpunkte direkt in den Support zu integrieren. Auch hier weist der Kryostat jedoch keine zwei Heliumtanks auf. Außerdem haben die in Referenz [4] offenbarten Befestigungsstrukturen hier zwingend eine konischzylindrische Form.

Die US-A 4,77,807 (=Referenz [5]) beschreibt eine Kryostatanordnung mit aktiv gekühlten Strahlungsschilden, die den Wärmefluss in die kalte Region des Kryostaten reduzieren. In einer dort beschriebenen Ausführungsform ist ein Strahlungsschild mit einer Befestigungsstruktur thermisch verbunden. Auch hier weist der Kryostat jedoch keine zwei Heliumtanks auf. Außerdem werden die Strahlungsschilde durch die erste Stufe eines Kryokühlers gekühlt (in der Beschreibung wird ein GM Kühler erwähnt), deren Temperatur höher ist als die Temperatur der zweiten Stufe und des ebenfalls erwähnten Heliumvorratstanks.

Die GB 2463659 A (=Referenz [6]) beschreibt einen Kryostaten, der mit einem Balg ausgestattet ist, der an einem Ende mit einem Strahlungsschild und am anderen Ende beweglich mit einem Kryogenbehälter verbunden ist. Diese Vorrichtung dient dem Zweck, den Strahlungsschild bei Bedarf durch verbesserten Kontakt zum Kryogentank abkühlen zu können. Der in Referenz [6] beschriebene Kryostat verfügt jedoch nicht über zwei Heliumtanks, und auch nicht über einen JT Kühler. Außerdem wird in Referenz [6] ein thermischer Kurzschluss zum kältesten Punkt des Systems (dem "cryogen vessel") hergestellt. Zur Verlängerung der Haltezeit im Falle des Ausfalls eines aktiven Kühlers ist dies jedoch nicht hilfreich, da die Wärmelast auf den kältesten Punkt des Systems -dessen Aufwärmrate es ja zu beschränken gilt- auf diese Weise nur erhöht wird.

Die EP 0 284 875 A2 (=Referenz [7]) beschreibt ein Aufhängungssystem mit Halterungen für einen NMR-Kryostaten. Die beschriebenen Befestigungselemente zwischen dem Heliumtank und dem Außenbehälter sind thermisch mit den dazwischenliegenden Strahlungsschilden verbunden. Der in der Referenz [7] beschriebene Kryostat weist jedoch keine zwei Heliumtanks auf, und für die Kühlung der Schilde bzw. der mit den Schilden verbundenen Aufhängungen ist nur eine Kühlung durch eine Wärmesenke mit einer Temperatur, die höher ist als die Temperatur des Vorratstanks, vorgesehen. Die EP 0 260 036 A2 (=Referenz [8]) zeigt eine Kryostatanordnung mit flexibel und wärmeleitend angekoppelten Befestigungselementen.

In der eingangs zitierten Referenz [1] wird ein gattungsgemäßer unterkühlter Horizontal-Kryostat mit zwei Tanks (Spulentank, Vorratstank) beschrieben. Auf die Problematik der thermischen Verankerung der Befestigungsstruktur wird allerdings nicht eingegangen. Der Spulentank wird, wie bereits oben erwähnt, auf eine Temperatur von etwa 2 K abgekühlt. Dies erfolgt mittels eines Joule-Thomson Refrigerators, in dem Helium entspannt wird. Für eine Druckverringerung wird üblicherweise eine Drehschieberpumpe eingesetzt.

Nachteilig am gegenwärtig bekannten Stand der Technik ist, dass die Wärme, die über die mechanischen Halterungen fließt, direkt in den Spulentank gelangt, und ausgerechnet dort - wo naturgemäß am wenigsten Kühlleistung zur Verfügung steht - absorbiert werden muss.

Als nachteilig erweist sich dieser Stand der Technik im Falle eines Ausfalls eines der aktiven Kühlsysteme:
- Wenn die Pumpe ausfällt, die zum Entspannen des Heliums verwendet wird (z.B. im Falle eines Stromausfalls oder bei einem mechanischen Defekt der Pumpe), führt die Wärme, die über die mechanische Aufhängung in den Spulentank fließt, zu einer verhältnismäßig schnellen Erwärmung des Spulentanks.
- Bei einem Ausfall des aktiven Kühlers, der den Strahlungsschild kühlt, oder - im Falle eines mit flüssigem Stickstoff gefüllten Tanks - bei kompletter Entleerung dieses Tanks, steigt die Schildtemperatur aufgrund der verhältnismäßig geringen Wärmekapazität des Schildes bzw. der geringen Wärmekapazität des leeren Tanks schnell an, was zu einem großen Anstieg der Wärmelast auf den Spulentank führt (die Wärmelast auf den Spulentank steigt in erster Näherung quadratisch mit der Temperatur des Schilds).

Eine Erwärmung des Spulentanks ist aber äußerst kritisch, da die Magnetspule schon bei einer geringen Überschreitung der Designtemperatur quencht (d.h. in den normalleitenden Zustand übergeht, wobei die im Spulenstrom gespeicherte hohe Energie aufgrund des dann ohmschen Widerstands der Spule sehr rasch in Wärme umgesetzt wird).

### Aufgabe der Erfindung

Der vorliegenden Erfindung liegt demgegenüber die -im Detail betrachtet relativ anspruchsvolle und komplexe- Aufgabe zugrunde, eine Kryostatanordnung der eingangs beschriebenen Art mit einem supraleitenden Magnetspulensystem mit möglichst unaufwändigen technischen Mitteln dahingehend zu verbessern, dass die oben diskutierten Nachteile bekannter gattungsgemäßer Anordnungen vermieden werden. Insbesondere soll die Kryostatanordnung bei eventuellen Betriebsstörungen eine ausreichend lange "Time-to-Quench" ermöglichen, und gleichzeitig einfach und zuverlässig im Aufbau sowie kostengünstig in der Herstellung sein.

### Kurze Beschreibung der Erfindung

Diese Aufgabe wird durch die vorliegende Erfindung auf ebenso überraschend einfache wie wirkungsvolle Weise dadurch gelöst, dass bei einer Kryostatanordnung der eingangs definierten Art die Befestigungsstruktur mehrere Befestigungselemente umfasst, welche jeweils mindestens einen thermisch leitenden Kontaktpunkt aufweisen, der über mindestens ein thermisches Leiterelement jeweils thermisch an mindestens eine Wärmesenke, deren Temperatur kleiner oder gleich der des Vorratstanks ist, angekoppelt ist, dass mindestens eine Wärmesenke den Vorratstank umfasst, und dass das thermische Leiterelement Rohrschleifen umfasst, über welche eine thermische Ankopplung zwischen den Kontaktpunkten und dem Vorratstank erfolgt, wobei die Rohrschleifen unterhalb einer Flüssigkeitsoberfläche des ersten kryogenen Fluids aus dem Vorratstank abzweigen, zu den Kontaktpunkten führen, und dann an einen Ort des Vorratstanks zurückgeführt sind, der oberhalb der Flüssigkeitsoberfläche liegt.

Die Grundidee der vorliegenden Erfindung besteht darin, die Wärme, die über die mechanische Aufhängung ins System fließt, derart abzuleiten, dass Sie anstatt in den Spulentank in die Wärmesenke fließt.

Bei einem Ausfall der Pumpe oder der Kühlung eines Strahlungsschilds steigt die Temperatur des Spulentanks dann viel langsamer an, und die "Time-to-Quench" verlängert sich deutlich.

Ähnlich zu der unten beschriebenen Lösung mit Heatpipes ist es möglich, die Kontaktpunkte direkt mit Rohrschleifen zu verbinden die wiederum mit dem Vorratstank verbunden sind. Helium aus dem Vorratstank kann so durch diese Rohrschleifen zu den Kontaktpunkten fließen. Dort wird die Wärme aus den Befestigungselementen vom Helium absorbiert, das in Folge verdampft. Das gasförmige Helium steigt dann durch den zweiten Zweig der Rohrschleife zurück in den Vorratstank, und wird dort direkt in die Gasphase eingeleitet. Die Bewegung des Fluids durch die Rohrschleife wird durch natürliche Konvektion -also vollständig passiv- getrieben. Bei der Gestaltung der Rohrschleife ist darauf zu achten, dass die aufsteigenden Gasblasen leicht nach oben entweichen können, d.h. dass die Rückleitung zur Gasphase im Vorratstank keine zu langen Abwärtspassagen aufweist.

Mit der vorliegenden Erfindung werden insbesondere folgende Vorteile erzielt:
Die Wärmelast auf den Spulentank kann durch die hinsichtlich ihrer thermischen Eigenschaften deutlich effizientere Gestaltung der Befestigungsstruktur erheblich verringert werden.

Bei aktiv gekühlten Systemen ermöglicht dies den Einsatz eines Kühlers mit geringerer Kühlleistung, was sich zum Beispiel vorteilhaft auf den Stromverbrauch und die Systemkosten auswirkt.

Bei badgekühlten Systemen führt dies zu einer Verringerung der Abdampfrate des kryogenen Fluids. Dies hat zum einen eine deutliche Verringerung der Betriebskosten zur Folge, auf der anderen Seite vergrößert sich auch das Zeitintervall, in dem das kryogene Fluid (typischerweise Helium) nachgefüllt werden muss, was die Störungen bei langandauernden Kernspinresonanz-Messungen reduziert und insgesamt die Verfügbarkeit des Systems für NMR-Messungen erhöht.

Ein Hauptvorteil der vorliegenden Erfindung besteht darin, dass der Wärmeeintrag über die Befestigungselemente vom Außenbehälter und/oder von den Strahlungsschilden nicht direkt in den Spulentank fließt, sondern in die Wärmesenke abgeleitet wird und die Kühlung der Wärmesenke thermodynamisch günstiger erfolgt als die Kühlung des Spulentanks. Dies wird dadurch erreicht, dass die Wärmesenke bei einer höheren Temperatur betrieben wird als der zur Kühlung des Spulentanks verwendete Kühler. Wenn die Wärmesenke den Vorratstank umfasst, macht man sich zunutze, dass bei der höheren Temperatur des Vorratstanks (ca. 4,2 K statt T < 3,5 K) Kühlleistung dort "kostengünstiger" zu Verfügung steht.

Besonders relevant ist dies in zwei speziellen Szenarien:
Ausfall der Kühlung des Strahlungsschilds: Die Schilde werden typischerweise mit flüssigem Stickstoff oder mittels eines Kryokühlers (z.B. eines Pulsrohrkühlers) gekühlt. Fällt die Kühlung des Strahlungsschilds aus, steigt die Temperatur des Schilds schnell an. In erster Näherung steigt der Wärmefluss über die Befestigungselemente mit dem Quadrat der Schildtemperatur (sowohl die Wärmeleitfähigkeit der Befestigungselemente als auch der den Wärmefluss treibende Temperaturgradient wachsen linear mit der Schildtemperatur).

Ausfall der Kühlung des Spulentanks: Der Spulentank wird üblicherweise mittels eines Joule-Thomson Kühlers gekühlt, in dem Helium auf einen niedrigen Druck entspannt wird und sich so abkühlt. Fällt die aktive Kühlung des Spulentanks aus, beginnt dieser, sich langsam aufzuwärmen. Wird eine gewisse Maximaltemperatur überschritten, quencht der Magnet. Die Aufwärmrate ist bestimmt durch die "thermische Masse" des Spulentanks (d.h. in erster Näherung die Wärmekapazität des Tanks, der Spule und des Heliums) und der Wärmelast auf den Spulentank. Die Wärmelast auf den Spulentank wird üblicherweise durch den Wärmefluss durch die Befestigungselemente dominiert. Wenn dieser Wärmefluss verkleinert werden kann, verkleinert sich die Aufwärmrate, und die Time-to-Quench wird länger, was den Betrieb des Systems sicherer und weniger fehleranfällig macht.

### Bevorzugte Ausführungsformen und Weiterbildungen der Erfindung

Ganz besonders bevorzugt ist eine Ausführungsform der erfindungsgemäßen Kryostatanordnung, bei der das zweite kryogene Fluid unterkühltes Helium ist, wobei der Druck des unterkühlten Heliums über dem der Temperatur des zweiten kryogenen Fluids entsprechenden Sättigungsdampfdruck liegt. Typischerweise wird das zweite kryogene Fluid beim gleichen Druck betrieben wie das erste kryogene Fluid - üblicherweise liegt dieser Druck 5 bis 100 mbar über dem Atmosphärendruck. Durch eine solche Betriebsweise wird vermieden, dass im Vorratstank oder im Spulentank Drücke unterhalb des Atmosphärendrucks herrschen, was die Betriebssicherheit des Systems erhöht: Im Falle eines kleinen oder großen Lecks oder im Falle von Fehlbedienung kann Luft nicht in die Heliumtanks "gesaugt" werden. Dies würde zu Vereisungen führen, welche wiederum wichtige Abströmleitungen blockieren könnten, die z.B. im Falle eines Quenches unbedingt benötigt werden.

Der Außenbehälter wird in der Regel als Vakuumbehälter ausgeführt sein, um eine hohe thermische Isolation zwischen den Bauteilen innerhalb des Behälters sicherzustellen.

Vorteilhaft sind auch Ausführungsformen der Erfindung, bei denen die Befestigungselemente aus einem Material gefertigt sind, bei welchem für das Verhältnis σ/θ von maximal zulässiger mechanischer Spannung σ, mit σ > 100 MPa, zum Integral θ der Wärmeleitfähigkeit λ über den Temperaturbereich ΔT zwischen 300 K und 4 K, mit θ < 300 W/m, gilt: σ/θ > 1/3 (MPa·m)/W.

Die Wärmelast auf den Kryogentank kann durch eine solche -hinsichtlich der thermischen Eigenschaften effizientere- Gestaltung der Befestigungselemente deutlich verringert werden. Bei aktiv gekühlten Systemen ermöglicht dies den Einsatz eines Kühlers mit geringerer Kühlleistung, was sich zum Beispiel vorteilhaft auf den Stromverbrauch und die Systemkosten auswirkt. Bei badgekühlten Systemen führt dies zu einer Verringerung der Abdampfrate des kryogenen Fluids. Dies hat zum einen eine deutliche Verringerung der Betriebskosten zur Folge, auf der anderen Seite vergrößert sich auch das Zeitintervall, in dem das kryogene Fluid (Helium) nachgefüllt werden muss, was die Störungen bei langandauernden Kernspinresonanz-Messungen reduziert und insgesamt die Verfügbarkeit des Systems für NMR-Messungen erhöht. Im Falle eines Ausfalls eines aktiven Kühlsystems (z.B. eines Pulsrohrkühlers oder eines Joule-Thomson-Kühlers) verlängert sich die Haltezeit (Time-to-Quench) eines Systems, wenn die Befestigungselemente effizient gestaltet sind.

Weitere bevorzugte Ausführungsformen der Erfindung zeichnen sich dadurch aus, dass die Befestigungselemente aus Kunststoff, vorzugsweise aus faserverstärktem Kunststoff, insbesondere aus GFK, besonders bevorzugt aus dem Faserverbundwerkstoff G10, gefertigt sind. Diese Kunststoffe erfüllen die Anforderungen hinsichtlich Festigkeit und Wärmeleitfähigkeit besonders gut. In Faserverbundwerkstoffen wie z.B. G10 verleihen die Fasern dem Bauteil besonders hohe Festigkeit. Entscheidend ist bei den Befestigungselementen das Verhältnis aus Festigkeit zu Wärmeleitfähigkeit. Möglich ist auch die Verwendung von Kohlefaser, allerdings nur bei einer Temperatur unterhalb von 80 K, wo sich sogar ein noch besseres Verhältnis von Festigkeit und integraler Wärmeleitfähigkeit ergibt.

Das Wärmeleitfähigkeitsintegral von Edelstahl ist etwa 30mal größer als das von G10. Allerdings ist Edelstahl auch erheblich fester als G10. Die 0.2 % Streckgrenze von Edelstahl, die vom Entwickler zur Auslegung herangezogen wird, beträgt typischerweise 360 MPa (für 1.4301); die Zugfestigkeit von G10 liegt bei etwa 270 MPa.

Selbst unter der konservativen Annahme, dass bei G10 ein Sicherheitsfaktor von 3 gegenüber der Zugfestigkeit angewandt wird, und dass Edelstahl bis an die Streckgrenze belastet werden kann, ist die Wärmeleitung über ein Befestigungselement aus Edelstahl [(270/3 MPa)I(1 W/cm)]/ [(360 MPa)/(30 W/cm)]= 7,5 mal so groß wie über ein Befestigungselement aus GFK mit der gleichen Tragfähigkeit.

Eine Klasse von Ausführungsformen der Erfindung ist dadurch gekennzeichnet, dass die Befestigungselemente als Strebenelemente ausgeführt sind, und dass die thermisch leitenden Kontaktpunkte auf oder in die Strebenelemente geklebt oder bei gewickeltem Aufbau der Strebenelemente mitgewickelt sind.

Diese Lösung hat den Vorteil, dass die Strebenelemente direkt mit dem Spulentank in Verbindung gebracht werden können, was aus mechanischer Sicht -in Bezug auf die Festigkeit der Konstruktion- besonders günstig ist. Um die effiziente Ableitung der Wärme zu gewährleisten (und zwar mit minimalen Temperaturgradienten zwischen dem Kontaktpunkt und der Strebe an der Stelle, wo der Kontaktpunkt an der Strebe angebracht ist), hat es sich als günstig erwiesen, die Kontaktpunkte direkt auf die Strebe zu kleben. Dafür sind Kleber mit hoher Wärmeleitfähigkeit besonders geeignet.

Bei Strebenelementen aus faserverstärktem Kunststoff ist es besonders vorteilhaft, wenn die Kontaktpunkte direkt bei der Fertigung der Strebenelemente in die Strebenelemente integriert werden können. Dann ist eine besonders gute Ableitung des Wärmestroms, der durch das Strebenelement fließt, in den Kontaktpunkt gewährleistet.

Bei einer -in der Regel alternativen- Klasse von Ausführungsformen weisen die Befestigungselemente die Form einer Schlaufe auf, wobei jede Schlaufe jeweils mindestens einen thermisch leitenden Kontaktpunkt aufweist.

Eine Schlaufe aus GFK ist besonders günstig, da die Fasern im Werkstoff dann ebenfalls als Schlaufe gewickelt werden können. Faserverbundwerkstoffe verlieren einen Teil ihrer Vorteile, wenn die Fasern im Werkstück unterbrochen werden (z.B. bei Kurzfasermaterialien oder bei Werkstücken, bei deren mechanischer Bearbeitung die Fasern durchtrennt werden). Jeder Unterbruch einer Faser schwächt das Werkstück mechanisch.

Außerdem ist es bei schlaufenförmigen Befestigungselementen besonders einfach, sie beim Einbau vorzuspannen, sodass sie unter allen im Betrieb auftretenden Lasten auf Zug beansprucht sind. Druckbelastungen können zu instabilem Versagen (Knicken) führen. Teile, die nur auf Zug ausgelegt werden müssen, können mit dünnerem Querschnitt ausgeführt werden können. Dies hilft wiederum, die Wärmelast klein zu halten.

Vorteilhaft sind auch Ausführungsformen der erfindungsgemäßen Kryostatanordnung, die dadurch gekennzeichnet sind, dass die Befestigungselemente an ihrem dem Spulentank zugewandten Ende einen thermisch leitenden Kontaktpunkt aufweisen, der auf der dem Befestigungselement abgewandten Seite über eine thermisch isolierende Platte in flächigem mechanischen Kontakt mit dem Spulentank steht. Bei diesen Ausführungsformen werden die Befestigungselemente nicht durch den Kontaktpunkt "unterbrochen". Das macht die Herstellung der Befestigungselemente einfacher und billiger. Die thermisch isolierende Platte ist typischerweise eine GFK Platte. Diese kann auf geeignete Weise ausgeschnitten werden, um die Wärmeleitung durch die Platte zu reduzieren.

Die thermischen Leiterelemente zur thermischen Ankopplung der Kontaktpunkte der Befestigungselemente an eine Wärmesenke können je nach Anwendung in unterschiedlicher Weise gestaltet sein:
Eine Klasse von Ausführungsformen zeichnet sich dadurch aus, dass das thermische Leiterelement aus einer Litze oder einem Stab aufgebaut ist und aus einem Material mit hoher Wärmeleitfähigkeit Lambda bei tiefen Temperaturen, insbesondere Lambda > 250W/(m*K), vorzugsweise Lambda > 500W/(m*K), bei einer Temperatur von 4K, hergestellt ist, bevorzugt aus hochreinem Kupfer oder hochreinem Aluminium.

Es ist günstig, wenn sich über die thermische Verbindung zwischen den Kontaktpunkten und dem Vorratstank bei einem gegebenen Wärmefluss ein möglichst kleiner Temperaturgradient ausbildet. Damit wird gewährleistet, dass die an den Kontaktpunkten an den Strebenelementen erreichte Temperatur minimal ist, und der Wärmeeintrag in den Spulentank so gering wie möglich ist. Der Temperaturgradient über die thermischen Verbindungselemente kann klein gemacht werden, wenn der Querschnitt der Verbindungselemente groß gewählt wird, wenn deren Länge klein ist, und wenn deren Wärmeleitfähigkeit hoch ist. Große Querschnitte sind konstruktiv schwierig, da die resultierenden großen Bauteile nur schwer in den beengten Verhältnissen eines Kryostaten untergebracht werden können. Das steht im Konflikt mit dem Wunsch, Magnetsysteme möglichst kompakt auszuführen. Die Länge der thermischen Verbindungselemente ist oftmals nicht frei wählbar, da die Distanz zwischen dem Vorratstank und den Kontaktpunkten durch andere Designkriterien (wie z.B. die Größe der Spule) vorgegeben ist. Am effizientesten lässt sich ein niedriger Temperaturgradient also durch den Einsatz geeigneter hochleitfähiger Materialien erreichen. In der Kryotechnik wird für solche Zwecke oft Kupfer oder Aluminium verwendet. Dabei ist darauf zu achten, dass die verwendeten Materialien möglichst rein von Verunreinigungen sind, und auch im Materialgefüge keine Versetzungen aufweisen. Dadurch wird die Wärmeleitfähigkeit bei tiefen Temperaturen nochmals verbessert.

Eine weitere Klasse von Ausführungsformen ist dadurch gekennzeichnet, dass das thermische Leiterelement eine Heatpipe umfasst oder aus einer Heatpipe aufgebaut ist. Heatpipes sind besonders gute Wärmeleiter, deren Funktionsweise nicht auf der Wärmeleitung in einem Festkörper beruht, sondern auf Konvektion in einem Fluid. Im konkreten Fall kämen hauptsächlich mit Helium befüllte Heatpipes in Frage. Alle anderen Fluide wären bei den auftretenden extrem niedrigen Temperaturen schon ausgefroren.

Besonders bevorzugt sind auch Ausführungsformen der Erfindung, bei denen mindestens eine Wärmesenke aus dem Vorratstank besteht. In dieser besonderes Ausbildungsform können die Heatpipes direkt mit dem Vorratstank verbunden werden, d.h. das Rohr ist dann mit flüssigem Helium bei etwa 4.2 K befüllt. Am Kontaktpunkt verdampft das Helium aufgrund der Wärmezufuhr aus den Befestigungselementen und steigt in Form von Gasblasen in den Vorratstank auf, und zwar durch das gleiche Rohr, durch das das flüssige Helium zu den Kontaktpunkten rinnt.

Bei einer anderen Klasse von Ausführungsformen umfasst das thermische Leiterelement einen Strahlungsschild, insbesondere einen 4,2K-Strahlungsschild oder ist es aus einem solchen aufgebaut.

Eine wesentliche Anforderung an ein Strahlungsschild verlangt, dass es möglichst isotherm ist. Dies bedingt üblicherweise, dass der Strahlungsschild aus einem Material mit guter Wärmeleitfähigkeit hergestellt ist, und dass die Geometrie des Strahlungsschilds so gewählt wird, dass von jedem Punkt des Strahlungsschilds guter Wärmetransport zu dem Punkt möglich ist, an dem der Strahlungsschild mit der "Wärmesenke" verbunden ist. Diese Anforderung ist identisch mit der Anforderung, die an das erfindungsgemäße thermische Leiterelement gestellt wird, weshalb es sich anbietet, die beiden Bauteile miteinander zu kombinieren. Die Kontaktpunkte werden dann direkt mit dem Strahlungsschild verbunden. Besonders einfach ist das bei der oben beschriebenen Ausführungsform mit der thermisch isolierenden Platte, da es hier ohne weiteres möglich ist, den Strahlungsschild optisch dicht auszuführen. Werden die Kontaktpunkte direkt in die Befestigungselemente integriert, müssen zur Durchführung der Befestigungselemente Ausschnitte im Strahlungsschild vorgesehen werden, die dann auf geeignete Weise optisch dicht verschlossen werden müssen, beispielsweise durch Superisolation.

Bei weiteren bevorzugten Ausführungsform der erfindungsgemäßen Kryostatanordnung ist ein aktiver Kühler, insbesondere ein Joule-Thomson-Refrigerator, mit Unterkühlpumpen vorgesehen, die bei Stromausfall mittels einer unterbrechungsfreien Stromversorgung (="uninterruptible power supply") weiterbetrieben werden können. Mindestens eine Wärmesenke umfasst das Abgas des aktiven Kühlers und eine Abgasleitung des aktiven Kühlers wird seriell oder parallel mit thermischem Kontakt an den Kontaktpunkten vorbeigeführt.

Zum Kühlen auf Temperaturen unterhalb von 4,2 K wird sehr oft ein Joule-Thomson-Kühler eingesetzt. Dieses Kühlverfahren beruht darauf, Helium zu entspannen. In Magnetsystemen wird oft flüssiges Helium auf einen Druck von zwischen 2 und 100 mbar entspannt, und die dabei entstehende Kühlleistung zur Kühlung der Magnetspule verwendet. Aus dem J-T Kühler strömt dann gasförmiges Helium mit einer Temperatur < 4,2 K zu den Pumpen, die typischerweise bei Raumtemperatur angeordnet sind. Die Enthalpie des kalten Gases kann genutzt werden, um Komponenten im Inneren des Kryostaten zu kühlen, z.B. Strahlungsschilde oder eben auch die Kontaktpunkte der Befestigungselemente. Das Gas strömt dann mit einer Temperatur von typischerweise zwischen 1,0 und 3,5 K aus dem J-T-Kühler zu den Kontaktpunkten, nimmt dort die Wärme aus den Befestigungselementen auf, erwärmt sich, und strömt dann unter Umständen noch weiter zu anderen Komponenten, die ebenfalls gekühlt werden müssen. Die Kühlleistung im Abgas des J-T-Kühlers hat zwei Hauptvorteile: Zum einen ist sie praktisch "gratis" verfügbar, da das Gas ohnehin abgepumpt werden muss. Außerdem steht sie bei sehr tiefen Temperaturen (nämlich schon bei der Temperatur des Spulentanks) zu Verfügung. Die Nutzung des Abgases des aktiven Kühlers ist thermodynamisch somit besonders günstig.

Prinzipiell können die Kontaktpunkte ausschließlich durch das kalte Gas in der Abgasleitung gekühlt werden. Diese Lösung hat allerdings den kleinen Nachteil, dass die Kühlleistung an den Kontaktpunkten nicht zu Verfügung steht, wenn der J-T Kühler nicht in Betrieb ist (z.B. weil er ausgefallen ist). Es ist deshalb vorteilhaft, die Kontaktpunkte sowohl mit der Abgasleitung als auch mit dem Vorratstank zu verbinden. Wenn der J-T Kühler ausfällt, werden die Kontaktpunkte durch die Verbindung zum Vorratstank gekühlt. Bei der Auslegung ist darauf zu achten, dass die Güte der beiden thermischen Verbindungen gut aufeinander abgestimmt wird - dies erfolgt nach dem Fachmann wohl bekannten thermodynamischen Grundsätzen. Konkret geht es darum, ein perfekte thermische Anbindung der Kontaktpunkte an den Vorratstank zu vermeiden. Dann hätten die Kontaktpunkte nämlich immer die Temperatur des Vorratstanks, und die Kühlung der Kontaktpunkte durch das Abgas aus dem J-T Kühler wäre wirkungslos. Auf der anderen Seite darf die thermische Anbindung der Kontaktpunkte an den Vorratstank auch nicht zu schlecht sein - sonst zeigt sie ja keine Wirkung, wenn der J-T Kühler nicht in Betrieb ist. Wie die beiden thermischen Verbindungen aufeinander abgestimmt werden, hängt von den Details der konkreten Anwendung ab.

Eine Abstimmung der Wärmeleitfähigkeiten der thermischen Verbindungen kann entfallen, wenn der thermische Kontakt zwischen dem Vorratstank und der Abgasleitung beweglich ausgeführt ist. Besonders elegant ist hier eine Lösung, bei der die Verbindung in Abhängigkeit vom Druck in der Abgasleitung geöffnet oder geschlossen wird, insbesondere durch ein mit dem Inneren der Abgasleitung verbundenes, mechanisch vorgespanntes Balgelement, mit welchem der Kontakt hergestellt oder getrennt werden kann, wobei das Balgelement derart ausgeführt ist, dass ein thermischer Kontakt erst oberhalb eines Abgasleitungsdrucks von 100 mbar hergestellt wird.

Im Normalbetrieb herrscht in der Abgasleitung ein niedriger Druck, typischerweise < 100 mbar. In diesem Betriebszustand sollen die Kontaktpunkte keine thermische Verbindung zum Vorratstank haben; die Kühlung der Kontaktpunkte erfolgt über das kalte Gas in der Abgasleitung. Bei Ausfall des J-T Kühlers (z.B. wenn die mechanischen Pumpen ausfallen) läuft die Abgasleitung voll, und erreicht in Kürze einen Druck > 100 mbar. Die thermische Kontaktierung zum Vorratstank kann nun mittels eines Balges und einer Federvorspannung so ausgeführt werden, dass sie bei einem Druck > 100 mbar automatisch hergestellt wird. In diesem Fall übernimmt der Vorratstank die Kühlung der Kontaktpunkte.

Mit besonderem Vorteil lässt sich die vorliegende Erfindung einsetzen, wenn in der Kryostatanordnung eine Raumtemperaturbohrung mit horizontaler Achse vorhanden ist. Horizontale Magnetbohrungen sind gerade für MRI-Systeme besonders günstig, da das Untersuchungsobjekt (z.B. ein Mensch oder ein Tier) dann waagerecht liegend in den Probenraum im Magnetzentrum eingebracht werden kann. In Systemen, in denen vorwiegend Flüssigkeiten untersucht werden, kommen oft vertikale Magnetbohrungen zum Einsatz, um sicherzustellen, dass die Flüssigkeitsoberfläche nicht im Probenvolumen liegt.

Innerhalb der Bohrung sind die Platzverhältnisse sehr begrenzt, und die Abstände zwischen der Wand des Außenbehälters, des Spulentanks und eventuell dazwischenliegenden Strahlungsschilden sind sehr klein. Berührungen müssen allerdings um jeden Preis vermieden werden. Bei vertikalen Magnetbohrungen verläuft der Gravitationsvektor parallel zur Achse der Bohrung, d.h. Verformungen aufgrund des Eigengewichts führen üblicherweise nicht zu Berührungen der Komponenten (Strahlungsschilde, etc.) innerhalb der Bohrung. Dies ist bei Systemen mit horizontaler Bohrung nicht so, weshalb die Aufhängungen des Spulentank bei Systemen mit horizontaler Bohrung besonders fest ausgeführt werden müssen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Vertikalschnittansicht einer Ausführungsform der erfindungsgemäßen Kryostatanordnung;
- Fig. 2: eine Vertikalschnittansicht einer Kryostatanordnung nach dem Stand der Technik;
- Fig. 3: eine schematische Detailansicht einer Ausführungsform der erfindungsgemäßen Kryostatanordnung mit einem Befestigungselement, in welches die thermisch leitenden Kontaktpunkte integriert sind;
- Fig. 4: eine Detailansicht einer Ausführungsform mit einem Befestigungselement, an dessen Spulentank-seitigem Ende ein Kontaktpunkt vorgesehen ist und über eine thermisch isolierende Platte in flächigem mechanischen Kontakt mit dem Spulentank steht;
- Fig. 5: eine Detailansicht einer Ausführungsform, in der das thermische Leiterelement Rohrschleifen umfasst;
- Fig. 6: eine Detailansicht einer Ausführungsform, in der das thermische Leiterelement die Abgasleitung eines aktiven Kühlers umfasst;
- Fig. 7: eine Detailansicht einer Ausführungsform, in der die Abgasleitung eines aktiven Kühlers das thermische Leiterelement kreuzt; und
- Fig. 8: eine Ausführungsform, bei welcher im Kreuzungsbereich von Abgasleitung und thermischem Leiterelement ein mechanisch vorgespanntes Balgelement angeordnet ist, mit welchem der thermische Kontakt hergestellt oder getrennt werden kann.

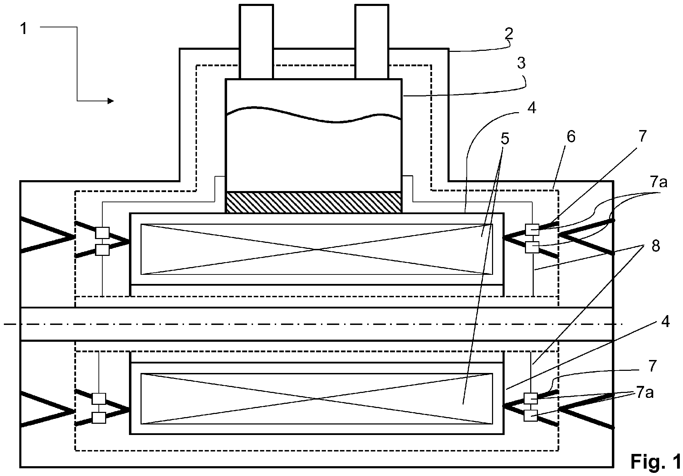

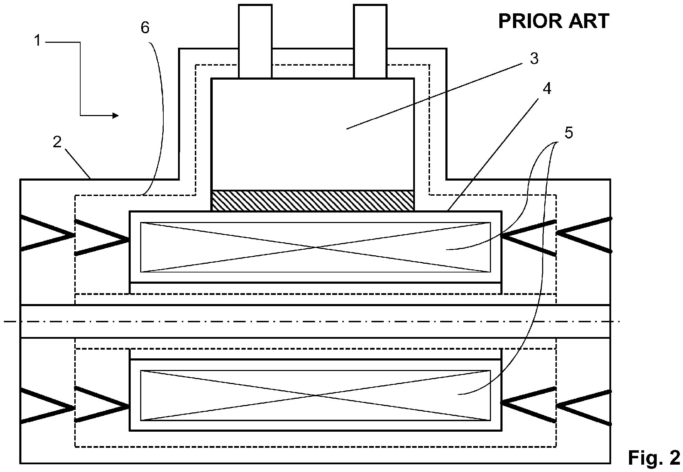

Die Figuren 1 und 3 bis 8 der Zeichnung zeigen jeweils in einer schematischen Ansicht in unterschiedlichem Detail bevorzugte Ausführungsformen der erfindungsgemäßen Kryostatanordnung zur Kühlung einer supraleitenden Magnetanordnung, während **Fig. 2** eine generische Kryostatanordnung nach dem nächstkommenden Stand der Technik darstellt.

Eine derartige **Kryostatanordnung 1** weist einen **Außenbehälter 2** auf, in welchem ein **Vorratstank 3** mit einem ersten kryogenen Fluid und ein **Spulentank 4** mit einem zu kühlenden supraleitenden **Magnetspulensystem 5** angeordnet sind. Das Magnetspulensystem 5 wird zumindest in einem Betriebszustand von einem zweiten kryogenen Fluid gekühlt, dessen Temperatur unter der des ersten kryogenen Fluids liegt. Der Spulentank 4 ist zumindest während eines Transportzustands mittels einer Befestigungsstruktur mit dem Außenbehälter 2 und/oder einem oder mehreren den Spulentank 4 umgebenden **Strahlungsschilden 6** mechanisch verbunden.

Die vorliegende Erfindung erweitert diese an sich bekannte Anordnung um folgende erfindungswesentlichen Elemente. Die erfindungsgemäße Kryostatanordnung 1 zeichnet sich gegenüber den Vorrichtungen aus dem Stand der Technik dadurch aus, dass die Befestigungsstruktur mehrere **Befestigungs-elemente 7; 7'** umfasst, welche jeweils mindestens einen **thermisch leitenden Kontaktpunkt 7a; 7a'** aufweisen, der über mindestens ein **thermisches Leiterelement 8; 8'** jeweils thermisch an mindestens eine Wärmesenke, deren Temperatur kleiner oder gleich der des Vorratstanks 3 ist, angekoppelt wird.

Bei Ausführungsformen der Erfindung kann mindestens eine Wärmesenke, an welche die thermischen Leiterelemente 8; 8' angekoppelt sind, den Vorratstank 3 umfassen, insbesondere aus dem Vorratstank 3 selbst bestehen.

Als zweites kryogenes Fluid wird in der Regel unterkühltes Helium eingesetzt, wobei der Druck des unterkühlten Heliums über dem der Temperatur des zweiten kryogenen Fluids entsprechenden Sättigungsdampfdruck liegt.

Der Außenbehälter 2 wird normalerweise als Vakuumbehälter ausgeführt sein und die am Spulentank 4 angebrachten Befestigungselemente 7; 7' werden an der Innenseite eines üblicherweise vorhandenen Strahlungsschilds 6 mechanisch befestigt, wie in **Fig. 1** gut zu erkennen ist.

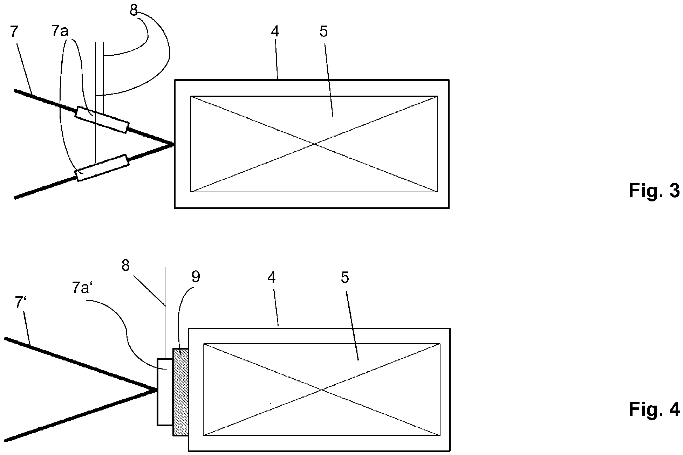

**Fig. 3** stellt die Ausführungsform nach Fig. 1 im Bereich des Spulentanks 4 in größerem Detail dar. Jedes Befestigungselement weist dann jeweils mindestens einen thermisch leitenden Kontaktpunkt 7a auf, der über ein thermisches Leiterelement 8 an eine Wärmesenke mit geringerer oder gleicher Temperatur wie der des Vorratstanks 3 thermisch angekoppelt ist.

Die Befestigungselemente 7; 7' können auch als Strebenelemente ausgeführt sein. Die thermisch leitenden Kontaktpunkte 7a; 7a' können dann auf oder in die Strebenelemente geklebt oder bei gewickeltem Aufbau der Strebenelemente mitgewickelt sein.

Die mechanischen Aufhängungen sind in der Regel aus GFK. In die GFK-Streben werden an geeigneter Stelle Strukturen (nämlich die Kontaktpunkte) direkt eingeklebt/mitgewickelt, und die thermische Kontaktierung erfolgt über diese Strukturen. Für die Strukturen wird ein Material mit hoher thermischer Leitfähigkeit bei tiefen Temperaturen bevorzugt, z.B. hochreines Kupfer oder hochreines Aluminium.

Details einer weiteren Ausführungsform sind in **Fig. 4** dargestellt. Hier weisen die Befestigungselemente 7'an ihrem dem Spulentank 4 zugewandten Endes einen thermisch leitenden Kontaktpunkt 7a' auf, der auf der dem Befestigungselement 7' abgewandten Seite über eine **thermisch isolierende Platte 9,** die als Abstandshalter wirkt, in flächigem mechanischen Kontakt mit dem Spulentank 4 steht.

Die thermischen Leiterelemente 8; 8' können aus einer Litze oder einem Stab aufgebaut sein, jedenfalls aus einem Material mit hoher Wärmeleitfähigkeit Lambda bei tiefen Temperaturen. Bei -in der Zeichnung nicht eigens dargestellten- weiteren Ausführungsformen können die thermischen Leiterelemente 8; 8' auch eine Heatpipe umfassen oder aus einer Heatpipe aufgebaut sein. Auch können die thermischen Leiterelemente 8; 8' einen Strahlungsschild, insbesondere einen 4,2K-Strahlungsschild umfassen oder aus einem solchen aufgebaut sein, was ebenfalls in der Zeichnung nicht eigens dargestellt ist.

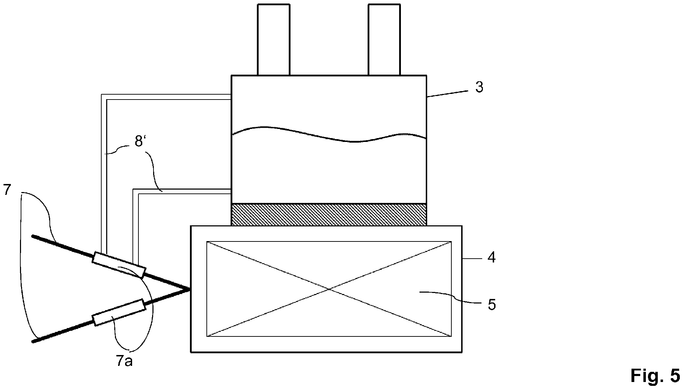

**Fig. 5** zeigt eine Ausführungsform, bei der das thermische Leiterelement 8' Rohrschleifen umfasst, über welche eine thermische Ankopplung zwischen den Kontaktpunkten 7a und dem als Wärmesenke wirkenden Vorratstank 3 erfolgt, wobei die Rohrschleifen unterhalb einer Flüssigkeitsoberfläche des ersten kryogenen Fluids aus dem Vorratstank 3 abzweigen, zu den Kontaktpunkten 7a führen, und dann an einen Ort des Vorratstanks 3 zurückgeführt sind, der oberhalb der Flüssigkeitsoberfläche liegt.

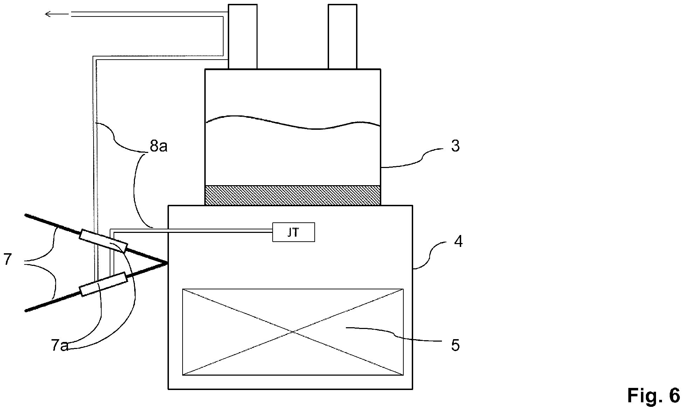

**Fig. 6** zeigt eine Ausführungsform, die einen aktiven Kühler, insbesondere einen **Joule-Thomson-Refrigerator JT** umfasst. Dabei sind -in der Zeichnung nicht eigens dargestellte- Unterkühlpumpen vorgesehen, die bei Stromausfall mittels einer unterbrechungsfreien Stromversorgung (="uninterruptible power supply") weiterbetrieben werden können. Mindestens eine Wärmesenke umfasst bei dieser Ausführungsform das Abgas des aktiven Kühlers, wobei eine **Abgasleitung 8a** des aktiven Kühlers seriell oder parallel mit thermischem Kontakt an den Kontaktpunkten 7a; 7a' vorbeigeführt ist.

Damit steht die zwischen den Temperaturbereichen von 2 K und 4,2 K ungenutzte Kühlleistung des LHe-Wärmeflusses von 0,4 mW/(ml/h) für das Abfangen der Wärme, die über die Supports in den Spulentank 3 fließt, zur Verfügung. Dies entspricht im Idealfall knapp der Hälfte der Kühlleistung des Refrigerators und kann diesen somit insbesondere im Notfall erheblich entlasten. Auch im Normalbetrieb erlaubt diese Anordnung eine deutliche Reduzierung des Wärmeflusses. In weiterer Folge kann das Abgas aus dem JT-Kühler, wie in Fig. 6 angedeutet, auch zum Abfangen der Wärmelast in den Halsrohren verwendet werden.

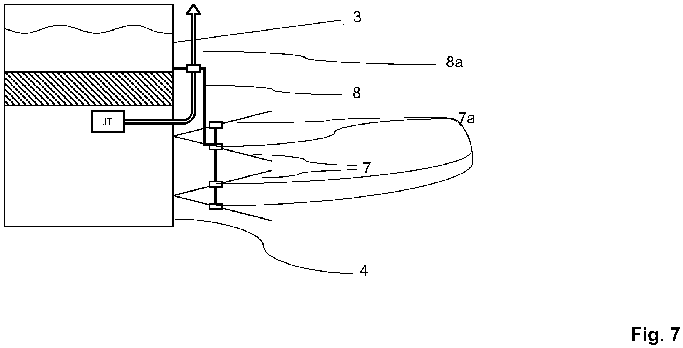

Eine weitere -gegebenenfalls auch ergänzende- Variante der Erfindung ist in **Fig. 7** dargestellt: Auch hier wird ein aktiver Kühler eingesetzt, vorzugsweise wieder ein Joule-Thomson-Refrigerator JT. Dessen Abgasleitung 8a wird dabei vom thermischen Leiterelement 8 auf seinem Weg zur Wärmesenke "gekreuzt".

Bei einem Ausfall der Unterkühlpumpen läuft die Abgasleitung 8a voll mit LHe, wobei sich die Phasengrenze (flüssig - gasförmig) dann irgendwo zwischen Austritt aus dem unten angeordneten Spulentank 4 und der thermischen Ankopplung am oben angeordneten Vorratstank 3 einstellt. Durch geeignete Wahl der thermischen Positionierung (beispielsweise durch unterschiedliche Leitfähigkeit der thermisch leitenden Kontaktpunkte 7a einerseits und dem Kreuzungsbereich beziehungsweise dem Ankoppelbereich an die Wärmesenke andererseits) kann das System zwischen höherer Verbrauchsreduzierung im Dauerbetrieb und Verlustreduzierung bei Pumpenausfall abgestimmt werden. Im Extremfall wird die thermische Leitfähigkeit des Ankoppelbereichs an die Wärmesenke sehr viel größer sein als die Leitfähigkeit des thermischen Leiterelements 8. Dann geht die Anordnung über in eine Ausführung ohne Wärmefluss-Ankopplung.

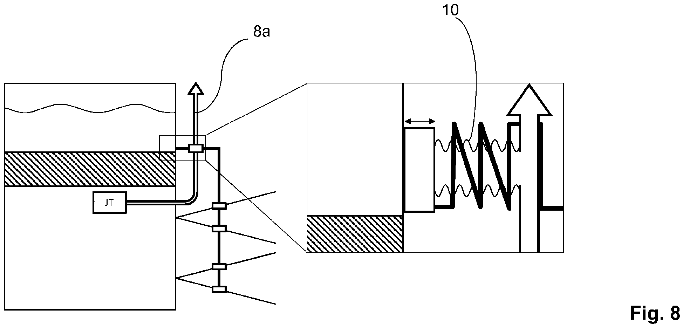

Eine vorteilhafte Weiterbildung dieser Ausführungsform ist in **Fig. 8** gezeigt: Dort ist der thermische Kontakt zwischen dem Vorratstank 3 und der Abgasleitung 8a beweglich ausgeführt. Hierzu ist ein mit dem Inneren der Abgasleitung 8a verbundenes, mechanisch -beispielsweise durch eine Federvorgespanntes **Balgelement 10** vorgesehen, mit welchem der thermische Kontakt hergestellt oder getrennt werden kann. Das Balgelement 10 soll in der Regel derart ausgeführt sein, dass ein thermischer Kontakt erst oberhalb eines Abgasleitungsdrucks von 100 mbar (also genau dann, wenn die Pumpen nicht mehr laufen) hergestellt wird.

Das gleiche Prinzip ist auch für Vertikal-Kryostaten denkbar, bei denen die mechanischen Aufhängungen direkt am Spulentank angreifen, z.B. um eine Kalttransportierbarkeit möglich zu machen.

### Referenzliste:

Für die Beurteilung der Patentfähigkeit in Betracht gezogene Druckschriften
[1] EP 1 742 234 B1, US 2010/0236260 A1
[2] US-A 5,220,800
[3] US-A 5,586,437
[4] US-A 6,011,454
[5] US-A 4,77,807
[6] GB 2463659 A
[7] EP 0 284 875 A2
[8] EP 0 260 036 A2

### Bezugszeichenliste:

- 1: Kryostatanordnung
- 2: Außenbehälter
- 3: Vorratstank
- 4: Spulentank
- 5: supraleitendes Magnetspulensystem
- 6: Strahlungsschild(e)
- 7; 7': Befestigungselemente
- 7a; 7a': thermisch leitende Kontaktpunkte
- 8; 8': thermische(s) Leiterelement(e)
- 8a: Abgasleitung des aktiven Kühlers
- 9: thermisch isolierende Platte
- 10: Balgelement
- JT: Joule-Thomson-Refrigerator

## Patentansprüche

1. Kryostatanordnung (1) mit einem Außenbehälter (2), in welchem ein Vorratstank (3) mit einem ersten kryogenen Fluid und ein Spulentank (4) mit einem zu kühlenden supraleitenden Magnetspulensystem (5) angeordnet sind,
wobei die Kryostatanordnung (1) so ausgestaltet ist, dass das Magnetspulensystem (5) von einem zweiten kryogenen Fluid gekühlt ist, dessen Temperatur unter der des ersten kryogenen Fluids liegt,
wobei der Spulentank (4) mittels einer Befestigungsstruktur mit dem Außenbehälter (2) und/oder einem oder mehreren den Spulentank (4) umgebenden Strahlungsschilden (6) mechanisch verbunden ist,
und wobei als erstes kryogenes Fluid im Vorratstank (3) flüssiges Helium bei einer Betriebstemperatur von etwa 4,2 K und als zweites kryogenes Fluid im Spulentank (4) Helium bei einer Betriebstemperatur < 3,5 K gewählt sind,
**dadurch gekennzeichnet,**
**dass** die Befestigungsstruktur mehrere Befestigungselemente (7; 7') umfasst, welche jeweils mindestens einen thermisch leitenden Kontaktpunkt (7a; 7a') aufweisen, der über mindestens ein thermisches Leiterelement (8; 8') jeweils thermisch an mindestens eine Wärmesenke, deren Temperatur kleiner oder gleich der des Vorratstanks (3) ist, angekoppelt ist,
**dass** mindestens eine Wärmesenke den Vorratstank (3) umfasst,
und **dass** das thermische Leiterelement (8') Rohrschleifen umfasst, über welche eine thermische Ankopplung zwischen den Kontaktpunkten (7a) und dem Vorratstank (3) erfolgt, wobei die Rohrschleifen unterhalb einer Flüssigkeitsoberfläche des ersten kryogenen Fluids aus dem Vorratstank (3) abzweigen, zu den Kontaktpunkten (7a) führen, und dann an einen Ort des Vorratstanks (3) zurückgeführt sind, der oberhalb der Flüssigkeitsoberfläche liegt.

2. Kryostatanordnung nach Anspruch 1, **dadurch gekennzeichnet, dass** das zweite kryogene Fluid unterkühltes Helium ist, wobei der Druck des unterkühlten Heliums über dem der Temperatur des zweiten kryogenen Fluids entsprechenden Sättigungsdampfdruck liegt.

3. Kryostatanordnung nach Anspruch 1 oder 2, **dadurch gekennzeichnet, dass** die Befestigungselemente (7; 7') aus einem Material gefertigt sind, bei welchem für das Verhältnis σ/θ von maximal zulässiger mechanischer Spannung o, mit σ > 100 MPa, zum Integral θ der Wärmeleitfähigkeit λ über den Temperaturbereich ΔT zwischen 300 K und 4 K, mit θ < 300 W/m, gilt: σ/θ > 1/3 (MPa m)/W.

4. Kryostatanordnung nach einem der vorhergehenden Ansprüche, **dadurch gekennzeichnet, dass** die Befestigungselemente (7; 7') aus Kunststoff, vorzugsweise aus faserverstärktem Kunststoff, insbesondere aus GFK, besonders bevorzugt aus dem Faserverbundwerkstoff G10, gefertigt sind.

5. Kryostatanordnung nach einem der Ansprüche 1 bis 4, **dadurch gekennzeichnet, dass** die Befestigungselemente (7; 7') als Strebenelemente ausgeführt sind, und dass die thermisch leitenden Kontaktpunkte (7a; 7a') auf oder in die Strebenelemente geklebt oder bei gewickeltem Aufbau der Strebenelemente mitgewickelt sind.

6. Kryostatanordnung nach einem der Ansprüche 1 bis 4, **dadurch gekennzeichnet, dass** die Befestigungselemente (7) die Form einer Schlaufe aufweisen, wobei jede Schlaufe jeweils mindestens einen thermisch leitenden Kontaktpunkt (7a) aufweist.

7. Kryostatanordnung nach einem der vorhergehenden Ansprüche, **dadurch gekennzeichnet, dass** die Befestigungselemente (7') an ihrem dem Spulentank (4) zugewandten Ende einen thermisch leitenden Kontaktpunkt (7a') aufweisen, der auf der dem Befestigungselement (7') abgewandten Seite über eine thermisch isolierende Platte (9) in flächigem mechanischen Kontakt mit dem Spulentank (4) steht.

8. Kryostatanordnung nach einem der Ansprüche 1 bis 7, **dadurch gekennzeichnet, dass** das thermische Leiterelement (8; 8') aus einer Litze oder einem Stab aufgebaut ist und aus einem Material mit hoher Wärmeleitfähigkeit Lambda bei tiefen Temperaturen, insbesondere Lambda > 250W/(m*K), vorzugsweise Lambda > 500W/(m*K), bei einer Temperatur von 4K, hergestellt ist, bevorzugt aus hochreinem Kupfer oder hochreinem Aluminium.

9. Kryostatanordnung nach einem der Ansprüche 1 bis 7, **dadurch gekennzeichnet, dass** das thermische Leiterelement (8; 8') eine Heatpipe umfasst oder aus einer Heatpipe aufgebaut ist.

10. Kryostatanordnung nach einem der Ansprüche 1 bis 7, **dadurch gekennzeichnet, dass** das thermische Leiterelement (8; 8') einen Strahlungsschild, insbesondere einen 4,2K-Strahlungsschild umfasst oder aus einem solchen aufgebaut ist.

11. Kryostatanordnung nach einem der vorhergehenden Ansprüche, **dadurch gekennzeichnet, dass** mindestens eine Wärmesenke aus dem Vorratstank (3) besteht.

12. Kryostatanordnung nach einem der vorhergehenden Ansprüche, **dadurch gekennzeichnet, dass** ein aktiver Kühler, insbesondere ein Joule-Thomson-Refrigerator (JT), mit Unterkühlpumpen vorhanden ist, die bei Stromausfall mittels einer unterbrechungsfreien Stromversorgung (="uninterruptible power supply") weiterbetrieben werden können, dass mindestens eine Wärmesenke das Abgas des aktiven Kühlers umfasst, und dass eine Abgasleitung (8a) des aktiven Kühlers seriell oder parallel mit thermischem Kontakt an den Kontaktpunkten (7a; 7a') vorbeigeführt ist.

13. Kryostatanordnung nach Anspruch 12, **dadurch gekennzeichnet, dass** der thermische Kontakt zwischen dem Vorratstank (3) und der Abgasleitung (8a) beweglich ausgeführt ist, insbesondere durch ein mit dem Inneren der Abgasleitung (8a) verbundenes, mechanisch vorgespanntes Balgelement (10), mit welchem der Kontakt hergestellt oder getrennt werden kann, wobei das Balgelement (10) derart ausgeführt ist, dass ein thermischer Kontakt erst oberhalb eines Abgasleitungsdrucks von 100 mbar hergestellt wird.

14. Kryostatanordnung nach einem der vorhergehenden Ansprüche, **dadurch gekennzeichnet, dass** eine Raumtemperaturbohrung mit horizontaler Achse vorhanden ist.

## Claims

1. Cryostat assembly (1) comprising an outer container (2) in which a storage tank (3) with a first cryogenic fluid and a coil tank (4) with a superconducting magnet coil system (5) to be cooled are arranged,
wherein the cryostat assembly (1) is designed such that the magnet coil system (5) is cooled by a second cryogenic fluid whose temperature is below that of the first cryogenic fluid,
the coil tank (4) being mechanically connected to the outer container (2) and/or to one or more radiation shields (6) surrounding the coil tank (4) by means of a mounting structure,
and liquid helium at an operating temperature of approximately 4.2 K being selected as the first cryogenic fluid in the storage tank (3) and helium at an operating temperature of < 3.5 K being selected as the second cryogenic fluid in the coil tank (4),
**characterized in**
**that** the mounting structure comprises a plurality of mounting elements (7; 7') which each have at least one thermally conductive contact point (7a; 7a') which is thermally coupled in each case to at least one heat sink, whose temperature is lower than or equal to that of the storage tank (3), by means of at least one thermal conductor element (8; 8'),
**that** at least one heat sink comprises the storage tank (3),
and in that the thermal conductor element (8') comprises tube loops by means of which the contact points (7a) and the storage tank (3) are thermally coupled, the tube loops branching away from the storage tank (3) below a liquid surface of the first cryogenic fluid, leading to the contact points (7a), and then being returned to a location on the storage tank (3) which is above the liquid surface.

2. Cryostat assembly according to claim 1, **characterized in that** the second cryogenic fluid is subcooled helium, the pressure of the supercooled helium being above the saturation vapor pressure corresponding to the temperature of the second cryogenic fluid.

3. Cryostat assembly according to either claim 1 or 2, **characterized in that** the mounting elements (7, 7') are made of a material for which, for the ratio σ/θ of maximum permissible mechanical stress σ, with σ > 100 MPa, to the integral θ of the thermal conductivity λ over the temperature range ΔT between 300 K and 4 K, with θ < 300 W/m, the following applies: σ/θ > 1/3 (MPa·m)/W.

4. Cryostat assembly according to any of the preceding claims, **characterized in that** the mounting elements (7; 7') are made of plastics material, preferably of fiber-reinforced plastics material, in particular of GFRP, particularly preferably of the fiber composite material G10.

5. Cryostat assembly according to any of claims 1 to 4, **characterized in that** the mounting elements (7; 7') are designed as strut elements, and **in that** the thermally conductive contact points (7a; 7a') are glued onto or into the strut elements or are co-wound in a wound structure of the strut elements.

6. Cryostat assembly according to any of claims 1 to 4, **characterized in that** the mounting elements (7) have the shape of a loop, each loop each having at least one thermally conductive contact point (7a).

7. Cryostat assembly according to any of the preceding claims, **characterized in that** the mounting elements (7') have, on their end facing the coil tank (4), a thermally conductive contact point (7a') which is in mechanical surface contact with the coil tank (4) via a thermally insulating plate (9) on the side facing away from the mounting element (7').

8. Cryostat assembly according to any of claims 1 to 7, **characterized in that** the thermal conductor element (8; 8') is constructed from a strand or a rod and is made of a material with high thermal conductivity lambda at low temperatures, in particular lambda > 250W/(m*K), preferably lambda > 500W/(m*K), at a temperature of 4 K, preferably made of high-purity copper or high-purity aluminum.

9. Cryostat assembly according to any of claims 1 to 7, **characterized in that** the thermal conductor element (8; 8') comprises a heat pipe or is constructed from a heat pipe.

10. Cryostat assembly according to any of claims 1 to 7, **characterized in that** the thermal conductor element (8; 8') comprises a radiation shield, in particular comprises a 4.2 K radiation shield, or is constructed from such a radiation shield.

11. Cryostat assembly according to any of the preceding claims, **characterized in that** at least one heat sink consists of the storage tank (3).

12. Cryostat assembly according to any of the preceding claims, **characterized in that** an active cooler, in particular a Joule Thomson refrigerator (JT), is provided with subcooling pumps, which can continue to be operated by means of an uninterruptible power supply in the event of a power failure, **in that** at least one heat sink comprises the exhaust gas of the active cooler, and **in that** an exhaust gas line (8a) of the active cooler is moved past the contact points (7a; 7a') serially or in parallel with thermal contact.

13. Cryostat assembly according to claim 12, **characterized in that** the thermal contact between the storage tank (3) and the exhaust gas line (8a) is designed to be movable, in particular by a mechanically preloaded bellows element (10) which is connected to the interior of the exhaust gas line (8a) and by means of which contact can be made or broken, the bellows element (10) being designed such that thermal contact is made only above an exhaust gas line pressure of 100 mbar.

14. Cryostat assembly according to any of the preceding claims, **characterized in that** a room temperature bore with a horizontal axis is provided.

## Revendications

1. Agencement de cryostat (1) comprenant une cuve extérieure (2) au sein de laquelle sont agencées une cuve de stockage (3) avec un premier fluide cryogénique et une cuve à bobines (4) avec un système de bobines magnétiques (5) supraconducteur à refroidir,
le dispositif cryostat (1) étant conçu de sorte que le système de bobines magnétiques (5) est refroidi par un second fluide cryogénique dont la température est inférieure à celle du premier fluide cryogénique,
la cuve à bobines (4) étant reliée mécaniquement à la cuve extérieure (2) au moyen d'une structure de fixation et/ou à une ou plusieurs protection(s) contre le rayonnement (6) entourant la cuve à bobines (4),
et le premier fluide cryogénique dans la cuve de stockage (3) étant de l'hélium liquide à une température de fonctionnement d'environ 4,2 K et le second fluide cryogénique dans la cuve à bobines (4) étant de l'hélium à une température de fonctionnement < 3,5 K,
**caractérisé en ce que**
la structure de fixation comprend plusieurs éléments de fixation (7 ; 7') présentant respectivement au moins un point de contact (7a ; 7a') thermiquement conducteur couplé thermiquement, par l'intermédiaire d'au moins un élément conducteur thermique (8 ; 8'), respectivement à au moins un puits de chaleur dont la température est inférieure ou égale à celle de la cuve de stockage (3),
**en ce qu'**au moins un puits de chaleur comprend la cuve de stockage (3),
et **en ce que** l'élément conducteur thermique (8') comprend des boucles de tuyauterie par l'intermédiaire desquelles a lieu un couplage thermique entre les points de contact (7a) et la cuve de stockage (3), les boucles de tuyauterie partant de la cuve de stockage (3) et passant sous une surface de liquide du premier fluide cryogénique pour mener aux points de contact (7a), puis étant renvoyées à un emplacement de la cuve de stockage (3) situé au-dessus de la surface de liquide.

2. Agencement de cryostat selon la revendication 1, **caractérisé en ce que** le second fluide cryogénique est de l'hélium sous-refroidi, la pression de l'hélium sous-refroidi étant supérieure à la pression de vapeur saturante qui correspond à la température du second fluide cryogénique.

3. Agencement de cryostat selon la revendication 1 ou 2, **caractérisé en ce que** les éléments de fixation (7 ; 7') sont fabriqués à partir d'un matériau pour lequel le rapport σ/θ de la tension mécanique maximale admissible σ, avec σ > 100 MPa, sur l'intégrale θ de la conductivité thermique λ sur la plage de température ΔT comprise entre 300 K et 4 K, avec θ < 300 W/m, vaut : σ/θ > 1/3 (MPa·m)/W.

4. Agencement de cryostat selon l'une quelconque des revendications précédentes, **caractérisé en ce que** les éléments de fixation (7 ; 7') sont fabriqués en plastique, de manière préférée en plastique renforcé de fibres, en particulier en PRV, de manière particulièrement préférée en matériau composite à base de fibres G10.

5. Agencement de cryostat selon l'une quelconque des revendications 1 à 4, **caractérisé en ce que** les éléments de fixation (7 ; 7') sont réalisés sous la forme d'éléments d'entretoise, et **en ce que** les points de contact (7a ; 7a') thermiquement conducteurs sont collés sur ou dans les éléments d'entretoise ou sont enroulés avec ceux-ci lors de la constitution des éléments d'entretoise par enroulement.

6. Agencement de cryostat selon l'une quelconque des revendications 1 à 4, **caractérisé en ce que** les éléments de fixation (7) présentent la forme d'une boucle, chaque boucle présentant respectivement au moins un point de contact (7a) thermiquement conducteur.

7. Agencement de cryostat selon l'une quelconque des revendications précédentes, **caractérisé en ce que** les éléments de fixation (T) présentent au niveau de leur extrémité tournée vers la cuve à bobines (4) un point de contact (7a') thermiquement conducteur qui est en contact mécanique à plat avec la cuve à bobines (4) du côté opposé à l'élément de fixation (T) par l'intermédiaire d'une plaque thermiquement isolante (9).

8. Agencement de cryostat selon l'une quelconque des revendications 1 à 7, **caractérisé en ce que** l'élément conducteur thermique (8 ; 8') est constitué d'un toron ou d'une baguette et est fabriqué en un matériau à haute conductivité thermique lambda à basse température, en particulier à lambda > 250W/(m*K), de manière préférée à lambda > 500W/(m*K), à une température de 4K, de manière préférée est fabriqué en cuivre de haute pureté ou en aluminium de haute pureté.

9. Agencement de cryostat selon l'une quelconque des revendications 1 à 7, **caractérisé en ce que** l'élément conducteur thermique (8 ; 8') comprend un caloduc ou est constitué d'un caloduc.

10. Agencement de cryostat selon l'une quelconque des revendications 1 à 7, **caractérisé en ce que** l'élément conducteur thermique (8 ; 8') comprend une protection contre le rayonnement, en particulier une protection contre le rayonnement 4,2K, ou est constitué d'une telle protection.

11. Agencement de cryostat selon l'une quelconque des revendications précédentes, **caractérisé en ce qu'**au moins un puits de chaleur est constitué par la cuve de stockage (3).

12. Agencement de cryostat selon l'une quelconque des revendications précédentes, **caractérisé en ce qu'**un refroidisseur actif, en particulier un réfrigérateur à effet Joule-Thomson (JT), est fourni, comprenant des pompes de sous-refroidissement pouvant continuer à fonctionner en cas de panne de courant au moyen d'une alimentation électrique sans interruption (=« uninterruptible power supply »), **en ce qu'**au moins un puits de chaleur assure l'échappement de gaz du refroidisseur actif, et **en ce qu'**une conduite d'échappement (8a) du refroidisseur actif est guidée en série ou en parallèle de manière à présenter un contact thermique au niveau des points de contact (7a ; 7a').

13. Agencement de cryostat selon la revendication 12, **caractérisé en ce que** le contact thermique entre la cuve de stockage (3) et la conduite d'échappement (8a) est réalisé de manière mobile, en particulier grâce à un élément formant soufflet (10) précontraint mécaniquement et relié à l'intérieur de la conduite d'échappement (8a) et avec lequel le contact peut être établi ou rompu, l'élément formant soufflet (10) étant réalisé de telle manière qu'un contact thermique n'est établi qu'au-dessus d'une pression de conduite d'échappement de 100 mbar.

14. Agencement de cryostat selon l'une quelconque des revendications précédentes, **caractérisé en ce qu'**un alésage à température ambiante à axe horizontal est fourni.
